# EUROPÄISCHE PATENTSCHRIFT

(11) **EP 0 890 879 B1**
(45) Veröffentlichungstag und Bekanntmachung des Hinweises auf die Patenterteilung: **18.12.2002**
(21) Anmeldenummer: 98112010.8
(22) Anmeldetag: 30.06.1998
(51) Int. Cl.: G03F 7/004, B41C 1/10

(54) **Infrarot-bebilderbares Aufzeichnungsmaterial und daraus hergestellte Offsetdruckplatte**
Infrared imageable material and offset printing plate made therefrom
Matériau pouvant être imagé par radiation infrarouge et plaque d'impression lithographique offset fabriquée à partir de ce matériau

(30) Priorität: 08.07.1997 DE 19729067
(43) Veröffentlichungstag der Anmeldung: 13.01.1999
(73) Patentinhaber: AGFA-GEVAERT, 2640 Mortsel (BE)
(72) Erfinder: Eichhorn, Mathias Dr., Yongsan-gu, Seoul (KR); März, Karin Dr., 64521 Gross-Gerau (DE); Grabley, Fritz-Feo Dr., 65779 Kelkheim (DE)

(56) Entgegenhaltungen:
- EP-A- 0 652 483
- EP-A- 0 683 435
- EP-A- 0 704 762
- EP-A- 0 750 230
- EP-A- 0 819 986
- US-A- 5 491 046
- US-A- 5 641 608
- PATENT ABSTRACTS OF JAPAN vol. 98, no. 9, 31. Juli 1998 (1998-07-31) & JP 10 087733 A (KONICA CORP.), 7. April 1998 (1998-04-07)

## Beschreibung

Die Erfindung betrifft ein mit Infrarot bebilderbares Aufzeichnungsmaterial zur Herstellung von Offsetdruckplatten, umfassend einen hydrophilen Träger und eine durch Infrarotstrahlung bebilderbare Schicht aus einem Gemisch, das
a) eine Komponente, die Infrarotstrahlung absorbiert und in Wärme umwandelt,
b) eine Verbindung, die unter der Einwirkung der durch die Komponente a) erzeugten Wärme Säure freisetzt, und
c) ein polymeres Bindemittel mit mindestens einer Gruppe, die durch die aus der Verbindung b) freigesetzte Säure gespalten wird,
enthält. Sie betrifft daneben ein Verfahren zur Herstellung einer Offsetdruckplatte aus dem Aufzeichnungsmaterial.

Bei der Herstellung von Druckformen für den Offsetdruck wird in konventionellen Verfahren eine Filmvorlage auf die strahlungsempfindliche Schicht gelegt. Durch die Vorlage hindurch wird dann mit ultraviolettem und/oder sichtbarem Licht bestrahlt. Neuere Entwicklungen ermöglichen es, Laserstrahlen computergesteuert auf die strahlungsempfindliche Schicht einwirken zu lassen. Auf diese Weise ist die direkte Umsetzung von digitalen Datenbeständen in ein bildmäßig bestrahltes Aufzeichnungsmaterial möglich; eine Filmvorlage ist nicht mehr erforderlich. Aufzeichnungsmaterialien, deren strahlungsempfindliche Schicht für Laserstrahlen mit Wellenlängen im Bereich des sichtbaren Lichts sensibilisiert ist, sind bekannt (EP-A 0 573 805 oder 0 704 764). Im sichtbaren Bereich emittierende Laser sind jedoch vergleichsweise teuer, so dass sich solche Aufzeichnungsmaterialien nicht durchsetzen konnten.

Infrarotlaser, speziell Laserdioden, sind dagegen wesentlich kostengünstiger. Dafür müssen jedoch Aufzeichnungsmaterialien zur Verfügung stehen, die "thermisch bebilderbar", d.h. in einem Wellenlängenbereich von etwa 700 bis 1100 nm sensibilisiert sind.

Solche thermisch bebilderbaren Materialien zur Herstellung von Druckplatten sind ebenfalls bereits bekannt. So ist in der EP-A 0 625 728 ein Material offenbart, dessen strahlungsempfindliche Schicht aus einem Gemisch besteht aus einem Resol, einem Novolak, einem Infrarot-Absorber und einer Verbindung, die bei Zersetzung eine Brönsted-Säure liefert. Die Infrarot-Absorber sind Farbstoffe oder Pigmente, die unter Strahlungseinwirkung fragmentieren, und so einen Belichtungskontrast erzeugen, insbesondere Cyanine, Merocyanine, Indolizine, Pyrylium- oder Squaryliumverbindungen. Als säureliefernde Verbindungen dienen insbesondere Oniumsalze. Bei Bestrahlung werden Infrarot-Absorber und Säurebildner zersetzt. Die bestrahlten Bereiche werden dadurch in einem wässrig-alkalischen Entwickler löslich. Das Löslichkeitsverhalten kehrt sich jedoch um, wenn das Material nach dem Bestrahlen erwärmt wird. Dann katalysiert die Brönsted-Säure eine Vernetzungsreaktion zwischen Resol und Novolak. Es sind dann die bestrahlten Bereiche der Schicht, die in einer wässrig-alkalischen Entwicklerlösung unlöslich sind. Das Material arbeitet somit in dieser Ausführungsform negativ. In der EP-A 0 672 954 ist ein ganz ähnliches Aufzeichnungsmaterial beschrieben. Statt des Oniumsalzes wird darin ein haloalkyl-substituiertes s-Triazin als Säurebildner eingesetzt.

In der EP-A 0 652 483 ist ein mit IR-Lasern thermisch bebilderbares Material beschrieben, aus dem ohne Entwicklung eine Druckplatte hergestellt wird. Die stahlungsempfindliche Schicht dieses Materials ist im unbestrahlten Zustand hydrophob und nimmt Offset-Druckfarbe an. Sie enthält eine Substanz, die Infrarotstrahlung absorbiert und in Wärme umwandelt sowie ein Polymer mit Gruppen, die unter der Einwirkung von Hitze und/oder Säure in hydrophilere und stärker polare Gruppen umgewandelt werden. Als reaktionsfähige Gruppen sind *tert*.-Alkyl-carboxylate, *tert*.-Alkyl-carbonate, Benzyl-carboxylate, Cyanobenzylester, Dimethylbenzylester und Alkoxyalkylester (insbesondere Tetrahydropyran-2-yl-ester) genannt. Vorzugsweise enthält die Schicht auch noch eine Verbindung, die bei Wärmeeinwirkung eine Säure hervorbringt. In den bestrahlten Bereichen nimmt die Schicht das wässrige Feuchtmittel an und stößt die Druckfarbe ab. Die Schicht bleibt jedoch insgesamt erhalten. Druckende (hydrophobe) und nicht-druckende (hydrophile) Bereiche unterscheiden sich nur durch ihre unterschiedliche Benetzbarkeit mit dem Feuchtmittel/Farbgemisch in der Druckmaschine. Mit einer solchen Druckplatte lässt sich aber nur eine sehr geringe Druckauflage (wenige tausend Drucke) erreichen. Zudem nehmen die hydrophilen Bereiche der Schicht das Feuchtmittel deutlich schlechter an als eine Aluminiumoxidfläche, was eine schlechtere Wasserführung bewirkt. Da belichtete und unbelichtete (noch hitzeempfindliche) Schichtbereiche nebeneinander vorliegen, kann eine solche Platte auch nicht durch Einbrennen mechanisch resistenter gemacht werden (was zu einer höheren Druckauflage führen würde). Als IR-Absorber werden solche Stoffe bevorzugt, die unter Einwirkung von IR-Strahlung Wärme *und* Säure erzeugen. Als Beispiele werden aromatische Diammoniumsalze starker Säuren genannt. Als zusätzliche Säurespender werden Trihalomethyl-s-triazine bevorzugt.

In der WO 90/12342 ist ein thermisch bebilderbares Material für Farbprüfverfahren beschrieben, bei dem polymere Bindemittel verwendet werden, die sich unter Einwirkung von Hitze und/oder Säure zersetzen. Die Expansion der freiwerdenden gasförmigen Zersetzungsprodukte in den IR-belichteten Bereichen des Materials führt zu einer Ablation. Durch den Transfer des ablatierten Materials von einem IR-transparenten Trägerfilm auf ein Empfangsblatt kann das gewünschte Farbbild erhalten werden. Dieses Verfahren arbeitet naturgemäß ohne Nassentwicklung. Als IR-Absorber werden Substanzen bevorzugt, die unter dem Einfluss von IR-Strahlung Hitze und Säure freisetzen (z.B. Diammoniumsalze starker Säuren). Auch Ruß wird als IR-Absorber erwähnt, dessen Nachteil aber in der ausschließlichen Verwendbarkeit für schwarze Teilfarbenbilder gesehen wird. Als Bindemittel dienen solche, die durch Säure schnell zersetzt werden, vorzugsweise bei Temperaturen unterhalb von 100°C, z. B. Nitrocellulose, Polycarbonate und bestimmte Polyurethane sowie andere Bindemittel, die unter Bildung tertiärer Carboniumionen mit anschließender Protonenelimination (Autokatalyse der Zersetzungsreaktion) thermolysiert werden können. Als Modell für letztere wird die bekannte thermisch und/oder säurekatalysierte Zersetzung von Phenolen mit *tert*.-Butyloxycarbonylgruppen unter Bildung von Kohlendioxid, Isobuten und Protonen erwähnt (s. auch: Fréchet et al., J. Imaging Sci. **30 (2)** [1986] 59). Die Bildung der gasförmigen Zersetzungsprodukte bewirkt die Ablation des Materials bei IR-Bestrahlung.

Materialien, die nach einer säurekatalysierten Thermolyse nass entwickelt werden, sind z.B. in der EP-A 0 366 590 und in Ito et al., Polym.Eng.Sci. **23** [1983] 1012, offenbart. Sie stellen die Grundlage für hochempfindlichen Photoresist dar, die für den UV-Bereich sensibilisiert sind. Bevorzugtes Polymer ist Poly(*tert*.-butoxycarbonyloxy-styrol). Nachteil dieser Materialien ist eine geringe thermische Stabilität, hervorgerufen durch eine autokatalytische Zersetzung unter Beteiligung im Polymer noch vorhandener saurer phenolischer Hydroxylgruppen (s. Ito et al., J. Polym. Sci. **24** [1986] 2971). Hinweise zur Verwendung dieser Materialien bei der Herstellung von Druckplatten, die sowohl in Hinsicht auf die Entwicklerresistenz als auch die Druckauflage besondere Anforderungen an Polymere stellen, gibt es dort ebensowenig wie solche auf eine Sensibilisierung für Strahlung im IR-Bereich.

Die Verwendung von Polymeren mit säurelabilen Gruppen als Bindemittel für Druckplatten ist in der EP-A 0 683 435 beschrieben. Die Polymere enthalten bevorzugt Monomereinheiten aus 4*-tert.*-Butoxycarbonyloxy-styrol (BOCST). Die höchste Empfindlichkeit für UV/VIS, der geringste Dunkelabtrag und die größte thermische Stabiltät werden erreicht, wenn außer den Monomereinheiten (I) mit säurelabiler Gruppe, z.B. BOCST, auch Monomereinheiten (II) mit phenolischen Hydroxygruppen und Monomereinheiten (III) mit mindestens einer aliphatischen Hydroxygruppe im Bindemittel vorhanden sind. Der Gehalt an (II+III) ist verantwortlich für eine gute Entwickelbarkeit in wässrig-alkalischer Lösung. Bei einem zu hohen Gehalt an (II) wird aufgrund der oben beschriebenen autokatalytischen Wirkung die thermische Stabilität des Bindemittels reduziert und der Dunkelabtrag erhöht. Bei einem teilweisen Ersatz der Monomereinheiten mit phenolischen Hydroxygruppen durch solche mit aliphatischen Hydroxygruppen wird die thermische Stabilität verbessert. Die thermische Stabilität ist auch deshalb von besonderer Bedeutung, da mit diesem Bindemittel hergestellte Druckplatten nach der Bebilderung und vor der Entwicklung eine Nacherwärmung bei ca. 100°C benötigen. Die besten Ergebnisse werden erzielt, wenn der Anteil an (I+III) 10 bis 80 % beträgt. Das beschriebene Material hat zwar eine ausgezeichnete Lagerstabilität bei erhöhten Temperaturen, ist jedoch nicht thermisch bebilderbar.

Es bestand daher die Aufgabe, ein Aufzeichnungsmaterial zu schaffen, aus dem sich durch bildmäßiges Bestrahlen mit lR-Strahlungsquellen, insbesondere IR-Lasern, und anschließendes Entwickeln Platten für den konventionellen Offsetdruck, also den Nass-Offsetdruck, herstellen lassen. Die Druckplatten sollen auch ohne nachträgliches Einbrennen eine hohe Druckauflage zulassen.

Gelöst wird die Aufgabe durch eine Kombination von IR-Absorber und thermischem Säurebildner mit Polymeren, die neben säurespaltbaren auch hydrophile Gruppen tragen. Gegenstand der vorliegenden Erfindung ist demnach ein Aufzeichnungsmaterial aus einem hydrophilen Träger und einer durch Infrarotstrahlung bebilderbaren Schicht aus einem Gemisch, das
a) eine Komponente, die Infrarotstrahlung absorbiert und in Wärme umwandelt,
b) eine Verbindung, die unter der Einwirkung der durch die Komponente a) erzeugten Wärme Säure freisetzt, und
c) ein polymeres Bindemittel mit mindestens einer Gruppe, die durch die aus der Verbindung b) freigesetzte Säure gespalten wird,
enthält und dadurch gekennzeichnet ist, dass das Bindemittel c) neben den säurespaltbaren Gruppen auch hydrophile Gruppen enthält, so dass die Schicht in den von der Infrarotstrahlung getroffenen Bereichen in einem wässrig-alkalischen Entwickler löslich wird. Die hydrophilen Gruppen sind bevorzugt phenolische oder aliphatische Hydroxygruppen, Carboxyl-, Mercapto-, Sulfonamido- oder Aminogruppen, wobei die phenolischen und aliphatischen Hydroxygruppen besonders bevorzugt sind. Ganz besonders bevorzugt sind Bindemittel c), die neben den säurespaltbaren Gruppen gleichzeitig phenolische und aliphatische Hydroxygruppen enthalten.

Bei dem Träger mit einer hydrophilen Oberfläche handelt es sich vorzugsweise um eine mechanisch, chemisch und/oder elektrochemisch aufgerauhte und anodisierte Folie oder Platte aus Aluminium oder einer Aluminiumlegierung. Das Gewicht der durch die Anodisierung erzeugten hydrophilen Aluminiumoxidschicht beträgt allgemein 0,5 bis 5,0 g/m², vorzugsweise 1,0 bis 3,0 g/m².

Die Infrarotstrahlung absorbierende Komponente a) nimmt die IR-Strahlung auf und wandelt sie in Wärme um. Sie entwickelt dabei selbst keine Säure. Vorzugsweise enthält bzw. besteht die Komponente a) aus Rußpartikeln. Geeignet sind insbesondere Flamm-, Furnace oder Channelruße mit einer mittleren Primärteilchengröße bis zu 80 nm. Die Primärteilchengröße liegt jedoch bevorzugt bei nicht mehr als 60 nm, besonders bevorzugt bei nicht mehr als 30 nm. Die nach dem allgemein bekannten Verfahren von Brunauer, Emmett und Teller gemessene Oberfläche ("BET-Oberfläche") liegt bei mindestens 30 g/m². In einer bevorzugten Ausführungsform sind die Ruße oxidiert oder nachoxidiert, wodurch saure Einheiten an der Oberfläche der Rußpartikel entstehen. Wässrige Dispersionen solcher Ruße zeigen einen pH-Wert von weniger als 7. Besonders geeignet sind Rußpartikel, die mit einem Polymer vordispergiert sind. Zur Vordispergierung kann das Bindemittel c) verwendet werden. Brauchbar sind aber auch andere Bindemittel, die in wässrig-alkalischer Lösung löslich sind, wie Phenolharze (Novolake), Polyvinylacetate, Polyvinylacetale, Polyvinylpyrrolidone, Polyvinylether, Poly(hydroxystyrole) oder Cellulosederivate.

Der Anteil der IR-absorbierenden Komponente a) beträgt vorzugsweise 1,0 bis 30,0 Gew.-%, besonders bevorzugt 5,0 bis 10,0 Gew.-%, jeweils bezogen auf das Gesamtgewicht der nichtflüchtigen Bestandteile des Gemisches.

Als Säurebildner b) werden solche Substanzen verwendet, die unter der Einwirkung der vom IR-Absorber a) erzeugten Wärme eine starke Säure freisetzen. Bevorzugte Säurebildner sind Diazonium-, Phosphonium-, Sulfonium- und lodoniumsalze starker Säuren. Besonders bevorzugt sind Hexafluorophosphate, Hexafluoroantimonate und halogenierte Alkansulfonate (bevorzugt aromatische oder heteroaromatische Mono- oder Bisdiazonium-1,1,2,3,3,3-Hexafluorpropansulfonate). Die Azidität des bei der Zersetzung von Trichlormethyl-s-triazinen freigesetzten Chlorwasserstoffs reicht dagegen für eine Spaltung der säurelabilen Gruppe ohne Nacherwärmung nicht aus, so dass sich diese Verbindungen überraschenderweise nicht als Säurespender im Sinne der Erfindung nutzen lassen.

Der Anteil der säurebildenden Verbindung b) beträgt bevorzugt 0,1 bis 20,0 Gew.-%, besonders bevorzugt 1,0 bis 10,0 Gew.-%, jeweils bezogen auf das Gesamtgewicht der nichtflüchtigen Bestandteile des Gemisches.

Die säurespaltbare Gruppe in dem polymeren Bindemittel c) enthält vorzugsweise mindestens eine säurespaltbare C-O-C-Bindung. Besonders geeignete säurespaltbare Gruppen dieser Art entsprechen der Formel -O-CO-OR², worin R² einen (C₃-C₁₁)Alkyl-, (C₃-C₁₁)Alkenyl- oder (C₇-C₁₁)Aralkylrest, bevorzugt einen C₄-Alkylrest, besonders bevorzugt einen *tert*.-Butylrest, bedeutet. Die säurespaltbare Gruppe der Formel -O-CO-OR² ist zweckmäßig an eine in der Hauptoder Seitenkette des Polymers befindliche, gegebenenfalls substituierte Phenyl- oder Phenylengruppe gebunden.

Die aliphatischen Hydroxygruppen in dem polymeren Bindemittel c) sind bevorzugt Hydroxy(C₂-C₈)alkoxygruppen oder Dihydroxy(C₂-C₈)alkoxygruppen.

In einer besonders bevorzugten Ausführungsform ist das polymere Bindemittel c) ein Mischpolymer mit Monomereinheiten, die mindestens eine säurespaltbare C-O-C-Bindung enthalten, Monomereinheiten, die mindestens eine aliphatische Hydroxygruppe enthalten, und Monomereinheiten, die mindestens eine phenolische Hydroxygruppe enthalten. Solche Bindemittel sind in der EP-A 0 683 435 beschrieben. Die Anteile der Monomereinheiten mit aliphatischen und der Monomereinheiten mit phenolischen Hydroxygruppen betragen zusammmen vorzugsweise mindestens 65 %, bezogen auf die Summe aller Monomereinheiten. Das Bindemittel c) kann ein Terpolymer sein, das nur aus diesen Monomereinheiten besteht. Der Anteil der Monomereinheiten mit säurelabilen Gruppen beträgt 20 bis 30 %, der der Monomereinheiten mit phenolischen Hydroxylgruppen 50 bis 60 % und der der Monomereinheiten mit aliphatischen Hydroxylgruppen 15 bis 25 %, jeweils bezogen auf die Gesamtzahl der Monomereinheiten. Das Comonomer mit aliphatischen Hydroxygruppen ist besonders bevorzugt 4-(2,3-Dihydroxypropoxy)-styrol. Die Synthese der erfindungsgemäßen Bindemittel ist in der EP-A 0 683 435 beschrieben. Das Copolymer kann aber auch noch weitere Monomereinheiten aufweisen, solange diese nicht die Entwickelbarkeit der Schicht beeinträchtigen.

Der Anteil des polymeren Bindemittels c) beträgt 20 bis 80 Gew.-%, bevorzugt 30 bis 60 Gew.-%, jeweils bezogen auf das Gesamtgewicht der nichtflüchtigen Bestandteile des Gemisches.

Die IR-sensibilisierte Schicht kann schließlich noch allgemein übliche Zusätze in geringen Mengen enthalten. Zur Verbesserung der Oberflächenstruktur kann beispielsweise eine geringe Menge an Silikonöl zugegeben werden. Weitere geeignete Additive sind u.a. Tenside.

Herstellen lässt sich das erfindungsgemäße Aufzeichnungsmaterial durch Beschichten des Trägers mit einer Dispersion des thermisch sensibilisierten Gemisches. Die flüssige Phase der Dispersion besteht aus üblichen Beschichtungslösemitteln, wie Tetrahydrofuran, Ethylenglykol-monomethylether, Ethylenglykol-monomethylether-acetat, Propylenglykol-monomethylether, Propylenglykol-monomethylether-acetat, Ethyllactat oder Butanon und den darin gelösten Bestandteilen [die Komponenten b) und c) sind in der Regel löslich in dem Beschichtungslösemittel]. Anschließend wird getrocknet, bis die Schicht praktisch frei von Lösemitteln ist. Eine Minute erwärmen auf etwa 100 °C reicht dazu in der Regel aus. Beschichtet werden kann durch Aufschleudem, Aufgießen oder auf ähnliche Weise. Das Gewicht der getrockneten, thermisch sensibilisierten Schicht beträgt etwa 0,5 bis 5 g/m², bevorzugt 1,0 bis 3,0 g/m², besonders bevorzugt 1,8 bis 2,5 g/m².

Gegenstand der vorliegenden Erfindung ist schließlich auch ein Verfahren zur Herstellung von Offsetdruckplatten aus dem erfindungsgemäßen Aufzeichnungsmaterial. In diesem Verfahren wird das Aufzeichnungsmaterial zunächst bildmäßig bestrahlt und anschließend in einem wässrig-alkalischen Entwickler entwickelt, wobei die bestrahlten Bereiche der bebilderbaren Schicht entfernt werden und die hydrophile Oberfläche des Trägers freigelegt wird. Zur Bestrahlung besonders geeignet sind übliche IR-Laser, z.B. Diodenlaser oder Nd-YAG-Laser, die Strahlung in einem Wellenlängenbereich von 700 bis 1500 nm, vorzugsweise 700 bis 1100 nm, emittieren. Zur Bestrahlung kann das Aufzeichnungsmaterial in einem Flachbettbelichter, einem Außen- oder einem Innentrommelbelichter positioniert werden.

Der wässrig-alkalische Entwickler hat allgemein einen pH-Wert von mindestens 8, bevorzugt von 10 bis 14. Er enthält als alkalische Komponente insbesondere Amine (insbesondere Ethanolamin), Borate, Carbonate (insbesondere Na₂CO₃), Hydroxide (insbesondere NaOH oder KOH), Silikate (insbesondere Ortho- oder Metasilikate) oder Phosphate (insbesondere Trinatriumphosphat). Bei Silikatentwicklern ist das Verhältnis von Siliciumdioxid zu Alkalioxid bevorzugt gleich oder größer als 1. Damit ist sichergestellt, dass die Aluminiumoxidschicht des Trägers nicht geschädigt wird. Daneben kann der Entwickler Puffersubstanzen, Komplexbildner, Entschäumer, (organische) Lösemittel, Korrosionsinhibitoren, Farbstoffe, Tenside und/oder Hydrotrope enthalten.

Nach dem Entwickeln kann die Druckplatte direkt in eine Druckmaschine eingespannt werden. Andernfalls wird sie zweckmäßig mit einer Gummierungslösung geschützt, die z. B. synthetische oder natürliche wasserlösliche (Co-)-Polymere, wie Polyvinylalkohol, Poly(meth)acrylsäure, Poly(meth)acrylamid, Polyhydroxyethyl(meth)acrylat, Polyvinylmethylether, Gelatine, Dextran, Pullulan, Cellulose, Gummi arabicum oder Alginsäure enthält.

Die Erfindung wird durch die folgenden Beispiele näher beschrieben, die die Erfindung illustrieren, aber nicht beschränken sollen. Gt steht dabei für Gewichtsteile. Prozente sind Gewichtsprozente, soweit nichts anderes angegeben ist.

Die Belichtungen erfolgten mit Hilfe eines Außentrommelbelichters mit einer nutzbaren IR-Laserleistung von 130 mW bei einer Wellenlänge von 1064 nm.

### Herstellungsbeispiel 1:

Herstellung der Bindemittel mit säurespaltbaren Gruppen, freien phenolischen Gruppen und aliphatischen Hydroxygruppen:

Die für die verschiedenen Bindemittel eingesetzten Mengen an Ausgangsmaterialien sind in Tabelle 1 zusammengestellt.

### Allgemeine Vorschrift:

Zu einer Lösung von Poly(4-hydroxy-styrol) (Mw = 4500 g/mol) (Menge: (A) in Tab.1) in 700 ml Propylenglykol-monomethylether wurden 2 ml einer 40%-igen Lösung von Benzyltrimethylammoniumhydroxid (®Triton B) in Methanol hinzugegeben. Anschließend wurde die in Tabelle 1 unter (B) angegebene Menge 2,3-Epoxy-propanol zugefügt. Dieses Gemisch wurde dann 7 Stunden lang unter Rückfluss erhitzt. Nach dem Abkühlen auf Raumtemperatur wurden 0,2 g 4-Dimethylamino-pyridin zugegeben. Unter ständigem Rühren wurde dann die unter (C) angegebene Menge Di-tert.-butyldicarbonat, gelöst in 100 ml Propylenglykol-monomethylether, über einen Zeitraum von 30 min zugetropft. Nach Beenden des Zutropfens wurde die Reaktion durch einstündiges Nachrühren bei Raumtemperatur vervollständigt. Die Gewinnung des Polymers erfolgte durch Eingießen der Reaktionslösung in Wasser unter kräftigem Rühren. Das Polymer wurde anschließend abfiltriert und dann im Vakuum bei 50°C getrocknet.

**Tabelle 1**

| Polymer | A | B | C |
|---|---|---|---|
| 1a | 192g | 16ml | 105g |
| 1b | 192g | 18,7ml | 87,5g |
| 1c | 192g | 16ml | 70g |

### Herstellungsbeispiel 2 (Vergleichsbeispiel:

Herstellung eines Bindemittels mit säurelabilen Gruppen, jedoch ohne freie phenolische Gruppen und ohne aliphatische Hydroxylgruppen:

Zu einer Lösung von 200 g Poly(4-hydroxy-styrol) (Mw = 4500 g/mol) in 800 ml Propylenglykol-monomethylether wurden 1,0 g 4-Dimethylamino-pyridin zugegeben. Unter ständigem Rühren wurden dann 350 g Di-*tert*.-butyl-dicarbonat, gelöst in 400 ml Propylenglykol-monomethylether, über einen Zeitraum von 60 min. zugetropft. Nach Beenden des Zutropfens wurde die Reaktion durch einstündiges Nachrühren bei Raumtemperatur vervollständigt. Die Gewinnung des Polymeren erfolgte durch portionsweises Eingießen der Reaktionslösung in Wasser unter kräftigem Rühren, Filtrieren und anschließendes Trocknen im Vakuum bei 50°C.

### Herstellungsbeispiel 3 (Vergleichsbeispiel):

Herstellung eines Bindemittels mit säurelabilen Gruppen und freien phenolischen Gruppen:

Zu einer Lösung von 200 g Poly(4-hydroxy-styrol) (Mw = 4500 g/mol) in 800 ml Propylenglykol-monomethylether wurden 0,4 g 4-Dimethylamino-pyridin zugegeben. Unter ständigem Rühren wurden 94 g Di-*tert*.-butyldicarbonat, gelöst in 100 ml Propylenglykol-monomethylether, über einen Zeitraum von 30 min zugetropft. Nach Beenden des Zutropfens wurde die Reaktion durch einstündiges Nachrühren bei Raumtemperatur vervollständigt. Die Gewinnung des Polymeren erfolgte durch Eingießen der Reaktionslösung in Wasser unter kräftigem Rühren, Filtrieren und anschließendes Trocknen im Vakuum bei 50°C.

### Anwendungsbeispiel 4:

Herstellung einer Druckplatte mit den Bindemitteln aus Herstellungsbeispielen 1 bis 3:

Auf Platten aus elektrochemisch aufgerauhtem und anodisiertem Aluminium wurden Mischungen aus

| | |
|---|---|
| 6,7 Gt | Bindemittel gemäß den Herstellungsbeispielen 1 bis 3, |
| 42 Gt | Propylenglykol-monomethylether, |
| 34 Gt | Tetrahydrofuran, |
| 0,5 Gt | 4-p-Tolylmercapto-2,5-dlethoxy-benzoldiazonlum-hexafluorophosphat, |
| 0,01 Gt | Silikonöl und |
| 17 Gt | Rußdispersion |

aufgeschleudert und 1 min bei 100°C getrocknet. Das Schichtgewicht betrug nach dem Trocknen 1,8 bis 2,2 g/m².

Die Rußdispersion bestand aus

| | |
|---|---|
| 10,0 Gt | Ruß (®Printex 25), |
| 55,2 Gt | Kresol-Xylenol Novolak (®Alnovol SPN 400, 45,3%ig in Propylenglykol-monomethylether-acetat), |
| 28,8 Gt | Propylenglykol-monomethylether und |
| 0,01 Gt | Silikonöl. |

Die in den Beispielen 1 bis 3 genannten Polymere konnten auch in Lösung, d.h. ohne vorheriges Ausfällen in Wasser, direkt zur Herstellung der beschriebenen Beschichtungslösungen eingesetzt werden.

Die so hergestellten Aufzeichnungsmaterialien wurden in einem Außentrommelbelichter mit einem IR-Laser der Wellenlänge 1064 nm bei einer Leistung von 130 mW und unterschiedlichen Drehzahlen des Zylinders bebildert. Eine Nacherwärmung der bestrahlten Aufzeichnungsmaterialien war nicht notwendig. Nach der Bebilderung wurde 1 min lang in einem Entwickler der folgenden Zusammensetzung entwickelt:

| | |
|---|---|
| 5,5 Gt | Natriumsilikat-Nonahydrat, |
| 3,4 Gt | Trinatriumphosphat-dodecahydrat, |
| 0,4 Gt | Mononatriumphosphat (wasserfrei) und |
| 90,7 Gt | vollentsalztes Wasser. |

Tabelle 2 gibt die Belichtungsergebnisse wieder. Als Maß für die Empfindlichkeit der Platte gilt die Drehzahl des Zylinders, die eine schleierfreie Bebilderung ermöglichte. Je höher diese Drehzahl ist, desto größer ist die Empfindlichkeit.

**Tabelle 2:**

| Bindemittel Nr. | Drehzahl [U/min] | Bemerkungen |
|---|---|---|
| 1a | 100 | |
| 1b | 120 | |
| 1c | 130 | |
| 2 | 50-500 | nicht entwickelbar |
| 3 | 150 | keine Entwicklerresistenz nach einwöchiger Lagerung bei 25 °C |

Bei der Verwendung der Druckplatten mit den Bindemitteln 1a bis 1c in einer konventionellen Offsetdruckmaschine wurden Auflagen von über 100.000 Exemplaren erreicht.

## Patentansprüche

1. Aufzeichungsmaterial zur Herstellung von Platten für den konventionellen Offsetdruck umfassend einen Träger mit einer hydrophilen Oberfläche und eine durch Infrarotstrahlung bebilderbare Schicht aus einem Gemisch, das
a) eine Komponente, die Infrarotstrahlung absorbiert und in Wärme umwandelt,
b) eine Verbindung, die unter der Einwirkung der durch die Komponente a) erzeugten Wärme Säure freisetzt, und
c) ein polymeres Bindemittel mit mindestens einer Gruppe, die durch die aus der Verbindung b) freigesetzte Säure gespalten wird,
enthält, **dadurch gekennzeichnet, dass** das Bindemittel neben den säurespaltbaren Gruppen hydrophile Gruppen enthält, so dass die Schicht in den von der Infrarotstrahlung getroffenen Bereichen in einem wässrig-alkalischen Entwickler löslich wird.

2. Aufzeichnungsmaterial gemäß Anspruch 1, **dadurch gekennzeichnet, dass** die hydrophilen Gruppen phenolische oder aliphatische Hydroxygruppen, Carboxyl-, Mercapto-, Sulfonamido- oder Aminogruppen sind.

3. Aufzeichnungsmaterial gemäß Anspruch 1, **dadurch gekennzeichnet, dass** das Bindemittel c) gleichzeitig phenolische und aliphatische Hydroxygruppen enthält.

4. Aufzeichnungsmaterial gemäß Anspruch 1, **dadurch gekennzeichnet, dass** die Infrarotstrahlung absorbierende Komponente a) Rußpartikel enthält oder aus Rußpartikeln besteht.

5. Aufzeichnungsmaterial gemäß einem oder mehreren der Ansprüche 1 bis 4, **dadurch gekennzeichnet, dass** der Anteil der Komponente a) 1,0 bis 30,0 Gew.-%, bevorzugt 5,0 bis 10,0 Gew.-%, beträgt, jeweils bezogen auf das Gesamtgewicht der nichtflüchtigen Bestandteile des Gemisches.

6. Aufzeichnungsmaterial gemäß einem oder mehreren der Ansprüche 1 bis 5, **dadurch gekennzeichnet, dass** die Verbindung (b) ein Diazonium-, Sulfonium- oder lodoniumsalz ist.

7. Aufzeichnungsmaterial gemäß einem oder mehreren der Ansprüche 1 bis 6, **dadurch gekennzeichnet, dass** der Anteil der Verbindung b) 0,1 bis 20,0 Gew.-%, bevorzugt 1,0 bis 10,0 Gew.-%, beträgt, jeweils bezogen auf das Gesamtgewicht der nichtflüchtigen Bestandteile des Gemisches.

8. Aufzeichnungsmaterial gemäß einem oder mehreren der Ansprüche 1 bis 7, **dadurch gekennzeichnet, dass** die säurespaltbare Gruppe in dem polymeren Bindemittel c) mindestens eine säurespaltbare C-O-C-Bindung enthält.

9. Aufzeichnungsmaterial gemäß Anspruch 8, **dadurch gekennzeichnet, dass** die säurespaltbare Gruppe der -O-CO-OR² entspricht, worin R² einen (C₃-C₁₁)Alkyl-, (C₃-C₁₁)Alkenyl- oder (C₇-C₁₁)Aralkylrest, bevorzugt einen C₄-Alkylrest, besonders bevorzugt einen *tert*.-Butylrest, bedeutet.

10. Aufzeichnungsmaterial gemäß Anspruch 9, **dadurch gekennzeichnet, dass** die säurespaltbare Gruppe der Formel -O-CO-OR² an eine in der Haupt- oder Seitenkette eines Polymers befindliche, gegebenenfalls substituierte Phenyl- oder Phenylengruppe gebunden ist.

11. Aufzeichnungsmaterial gemäß einem oder mehreren der Ansprüche 1 bis 10, **dadurch gekennzeichnet, dass** die aliphatischen Hydroxygruppen in dem polymeren Bindemittel c) Hydroxy(C₂-C₈)alkoxygruppen oder Dihydroxy(C₂-C₈)alkoxygruppen sind.

12. Aufzeichnungsmaterial gemäß einem oder mehreren der Ansprüche 1 bis 9, **dadurch gekennzeichnet, dass** das polymere Bindemittel c) ein Copolymer ist mit Monomereinheiten, die mindestens eine säurespaltbare C-O-C-Bindung enthalten, Monomereinheiten, die mindestens eine aliphatische Hydroxygruppe enthalten, und Monomereinheiten, die mindestens eine phenolische Hydroxygruppe enthalten.

13. Aufzeichnungsmaterial gemäß Anspruch 12, **dadurch gekennzeichnet, dass** der Anteil der Monomereinheiten mit aliphatischen oder phenolischen Hydroxygruppen zusammen mindestens 65 % beträgt, bezogen auf die Summe aller Monomereinheiten.

14. Aufzeichnungsmaterial gemäß einem oder mehreren der Ansprüche 1 bis 13, **dadurch gekennzeichnet, dass** der Anteil des polymeren Bindemittels c) 20 bis 80 Gew.-%, bevorzugt 30 bis 60 Gew.-%, beträgt, jeweils bezogen auf das Gesamtgewicht der nichtflüchtigen Bestandteile des Gemisches.

15. Aufzeichnungsmaterial gemäß einem oder mehreren der Ansprüche 1 bis 13, **dadurch gekennzeichnet, dass** der Träger eine mechanisch, chemisch und/oder elektrochemisch aufgerauhte, anodisch oxidierte Aluminiumfolie oder -platte ist.

16. Verfahren zur Herstellung einer Offsetdruckplatte, **dadurch gekennzeichnet, dass** ein Aufzeichnungsmaterial gemäß einem oder mehreren der Ansprüche 1 bis 15 mit Infrarotstrahlung bildmäßig bestrahlt und anschließend in einem wässrig-alkalischen Entwickler entwickelt wird, wobei die bestrahlten Bereiche der bebilderbaren Schicht entfernt werden und die Oberfläche des hydrophilen Trägers freigelegt wird.

17. Verfahren gemäß Anspruch 16, **dadurch gekennzeichnet, dass** zur Bestrahlung ein Infrarot-Laser eingesetzt wird.

## Claims

1. A recording material for producing plates for conventional offset printing, comprising a support having a hydrophilic surface and an infrared-imageable layer of a mixture comprising
a) a component which absorbs infrared radiation and converts it to heat,
b) a compound which releases acid under the action of the heat generated by component a), and
c) a polymeric binder having at least one group which is cleaved by the acid released from the compound b),
and wherein the binder comprises not only the acid-cleavable groups but also hydrophilic groups, so that the layer becomes soluble in an aqueous-alkaline developer in the areas struck by the infrared radiation.

2. The recording material according to claim 1, wherein the hydrophilic groups are phenolic or aliphatic hydroxyl groups, carboxyl, mercapto, sulfonamido or amino groups.

3. The recording material according to claim 1, wherein the binder c) simultaneously comprises phenolic and aliphatic hydroxyl groups.

4. The recording material according to claim 1, wherein the infrared-absorbing component a) comprises or consists of particles of carbon black.

5. The recording material according to any of claims 1 to 4, wherein the proportion of component a) is from 1.0 to 30.0% by weight, preferably from 5.0 to 10.0% by weight, based in each case on the overall weight of the nonvolatile constituents of the mixture.

6. The recording material according to any of claims 1 to 5, wherein the compound (b) is a diazonium, sulfonium or iodonium salt.

7. The recording material according to any of claims 1 to 6, wherein the proportion of compound b) is from 0.1 to 20.0% by weight, preferably from 1.0 to 10.0% by weight, based in each case on the overall weight of the nonvolatile constituents of the mixture.

8. The recording material according to any of claims 1 to 7, wherein the acid-cleavable group in the polymeric binder c) contains at least one acid-cleavable C-O-C bond.

9. The recording material according to claim 8, wherein the acid-cleavable group is of the formula -O-CO-OR² in which R² is a (C₃-C₁₁) alkyl, (C₃-C₁₁) alkenyl or (C₇-C₁₁) aralkyl radical, preferably a C₄-alkyl radical and, with particular preference, a tert-butyl radical.

10. The recording material according to claim 9, wherein the acid-cleavable group of the formula -O-CO-OR² is attached to a substituted or unsubstituted phenyl or phenylene group located in the main chain or side chain of a polymer.

11. The recording material according to any of claims 1 to 10, wherein the aliphatic hydroxyl groups in the polymeric binder c) are hydroxy- (C₂-C₈) alkoxy groups or dihydroxy(C₂-C₈)alkoxy groups.

12. The recording material according to any of claims 1 to 9, wherein the polymeric binder c) is a copolymer including monomer units comprising at least one acid-cleavable C-O-C bond, monomer units comprising at least one aliphatic hydroxyl group, and monomer units comprising at least one phenolic hydroxyl group.

13. The recording material according to claim 12, wherein the proportion of the monomer units having aliphatic or phenolic hydroxyl groups is together at least 65%, based on the sum of all monomer units.

14. The recording material according to any of claims 1 to 13, wherein the proportion of the polymeric binder c) is from 20 to 80% by weight, preferably from 30 to 60% by weight, based in each case on the overall weight of the nonvolatile constituents of the mixture.

15. The recording material according to any of claims 1 to 13, wherein the support is a mechanically, chemically and/or electrochemically roughened, anodically oxidized aluminum foil or plate.

16. A process for producing an offset printing plate, which comprises subjecting a recording material according to any of claims 1 to 15 to imagewise irradiation with infrared radiation and then developing the image in an aqueous-alkaline developer, whereupon the irradiated areas of the imageable layer are removed and the surface of the hydrophilic support is exposed.

17. The process according to claim 16, wherein irradiation is carried out using an infrared laser.

## Revendications

1. Matériau d'enregistrement pour la fabrication de clichés pour l'impression offset conventionnelle comprenant un support muni d'une surface hydrophile et une couche apte à porter une image par exposition à un rayonnement infrarouge, constituée d'un mélange qui contient
a) un composant qui absorbe le rayonnement infrarouge et qui le transforme en chaleur,
b) un composé qui libère un acide sous l'influence de la chaleur générée par le composant a)., et
c) un liant polymère comprenant au moins un groupe qui est clivé par l'acide libéré à partir du composé b),
**caractérisé en ce que** le liant contient, en plus des groupes aptes à être clivés par un acide, des groupes hydrophiles, de telle sorte que la couche est soluble dans les zones touchées par le rayonnement infrarouge, dans un révélateur aqueux-alcalin.

2. Matériau d'enregistrement selon la revendication 1, **caractérisé en ce que** les groupes hydrophiles sont des groupes hydroxyle phénoliques ou aliphatiques, des groupes carboxyle, des groupes mercapto, des groupes sulfonamide ou des groupes amino.

3. Matériau d'enregistrement selon la revendication 1, **caractérisé en ce que** le liant c) contient en même temps des groupes hydroxyle phénoliques et aliphatiques.

4. Matériau d'enregistrement selon la revendication 1, **caractérisé en ce que** le composant a) absorbant le rayonnement infrarouge contient des particules de noir de carbone ou bien est constitué par des particules de noir de carbone.

5. Matériau d'enregistrement selon une ou plusieurs des revendications 1 à 4, **caractérisé en ce que** la fraction du composant a) s'élève de 1,0 à 30,0 % en poids, de préférence de 5,0 à 10,0 % en poids, chaque fois rapportés au poids total des constituants non volatils du mélange.

6. Matériau d'enregistrement selon une ou plusieurs des revendications 1 à 5, **caractérisé en ce que** le composé b) est un sel de diazonium, de sulfonium ou d'iodonium.

7. Matériau d'enregistrement selon une ou plusieurs des revendications 1 à 6, **caractérisé en ce que** la fraction du composé b) représente de 0,1 à 20,0 % en poids, de préférence de 1,0 à 10,0 % en poids, chaque fois rapportés au poids total des constituants non volatils du mélange.

8. Matériau d'enregistrement selon une ou plusieurs des revendications 1 à 7, **caractérisé en ce que** le groupe apte à être clivé par un acide dans le liant polymère c) contient au moins une liaison C-O-C apte à être clivée par un acide.

9. Matériau d'enregistrement selon la revendication 8, **caractérisé en ce que** le groupe apte à être clivé par un acide répond à la formule -O-CO-R² dans laquelle R² représente un radical alkyle en C₃-C₁₁, un radical alcényle en C₃-C₁₁ ou un radical aralkyle en C₇-C₁₁, de préférence un radical alkyle en C₄, de manière particulièrement préférée, un radical tert.-butyle.

10. Matériau d'enregistrement selon la revendication 9, **caractérisé en ce que** le groupe apte à être clivé par un acide répondant à la formule -O-CO-R² est lié à un groupe phényle ou à un groupe phénylène le cas échéant substitué, fixé sur la chaîne principale ou sur la chaîne latérale d'un polymère.

11. Matériau d'enregistrement selon une ou plusieurs des revendications 1 à 10, **caractérisé en ce que** les groupes hydroxyle aliphatiques dans le liant polymère c) sont des groupes hydroxyalcoxy en C₂-C₈ ou des groupes dihydroxyalcoxy en C₂-C₈.

12. Matériau d'enregistrement selon une ou plusieurs des revendications 1 à 9, **caractérisé en ce que** le liant polymère c) est un copolymère comprenant des unités monomères qui contiennent au moins une liaison C-O-C. des unités monomères qui contiennent au moins un groupe hydroxyle aliphatique et des unités monomères qui contiennent au moins un groupe hydroxyle phénolique.

13. Matériau d'enregistrement selon la revendication 12, **caractérisé en ce que** la fraction des unités monomères comprenant des groupes hydroxyle aliphatiques ou phénoliques représente de manière conjointe au moins 65 %, rapportés à la somme de toutes les unités monomères.

14. Matériau d'enregistrement selon une ou plusieurs des revendications 1 à 13, **caractérisé en ce que** la fraction du liant polymère c) représente de 20 à 80 % en poids, de préférence de 30 à 60 % en poids, chaque fois rapportés au poids total des constituants non volatils du mélange.

15. Matériau d'enregistrement selon une ou plusieurs des revendications 1 à 13, **caractérisé en ce que** le support est une feuille ou une plaque d'aluminium qui a été rendue rugueuse par voie mécanique, par voie chimique et/ou par voie électrochimique et qui a été soumise à une oxydation par voie anodique.

16. Procédé pour la fabrication d'un cliché offset, **caractérisé en ce qu'**on expose en forme d'image à un rayonnement infrarouge un matériau d'enregistrement selon une ou plusieurs des revendications 1 à 5, et on le développe ensuite dans un révélateur aqueux-alcalin, dans lequel les zones exposées de la couche aptes à porter une image sont éliminées et la surface du support hydrophile est mise à nu.

17. Procédé selon la revendication 16, **caractérisé en ce qu'**on met en oeuvre un laser infrarouge pour l'exposition à un rayonnement.
